# EUROPÄISCHE PATENTANMELDUNG

(11) **EP 1 798 757 A2**
(43) Veröffentlichungstag der Anmeldung: **20.06.2007**
(21) Anmeldenummer: 06025277.2
(22) Anmeldetag: 07.12.2006
(51) Int. Cl.: H01L 21/00, B05D 5/08, F26B 5/08

(54) **Vorrichtung zum Reinigen und Trocknen von Wafern**

(30) Priorität: 15.12.2005 DE 102005059850
(71) Anmelder: ATMEL Germany GmbH, 74072 Heilbronn (DE)
(72) Erfinder: Hartlep, Raik, Dipl.-Chem., 74074 Heilbronn (DE)

(57) **Zusammenfassung**

Waferbearbeitungsvorrichtung (1), mit einer Prozesskammer (3), die mit einem Gehäuse (2) umgeben ist, einer Anordnung von Einlassöffnungen (9) innerhalb der Prozesskammer (3), die dazu vorgesehen sind, ein Fluid abzugeben und einer drehbaren Aufnahmevorrichtung (11) für Wafer (15), wobei die Wafer (15) in einem Waferträger (6) angeordnet sind, der an der Aufnahmevorrichtung (11) fixiert ist, bei der auf allen Fluid berührenden Teilen (2,4,7-9,11-14) der Waferbearbeitungsvorrichtung (1) eine Beschichtung aus einem Fluorpolymer, vorzugsweise PTFE vorgesehen ist.

## Beschreibung

Die vorliegende Erfindung betrifft eine Waferbearbeitungsvorrichtung gemäß dem Oberbegriff des Patentanspruchs 1.

Integrierte Schaltungen, wie Mikroprozessoren oder Speicherchips, und andere ähnliche Baugruppen werden üblicherweise auf dünnen runden Scheiben, so genannten Wafern, hergestellt. Diese unterliegen während ihrer Herstellung einer großen Anzahl an aufeinander folgenden Prozessschritten, eingeschlossen Reinigungsschritten, die üblicherweise in Spül- und Trockenvorgängen ausgeführt werden.

Die Fertigungsausbeute hochintegrierter Schaltungen ist in erheblichem Maße von der Sauberkeit der Wafer während des gesamten Prozesses abhängig. Verunreinigungen können dabei sowohl Partikel als auch chemische Kontaminationen sein, die aus der Prozessumgebung auf der Scheibenoberfläche angelagert werden. Beide Verunreinigungen können nicht streng voneinander getrennt werden, da chemische Bestandteile von Partikeln insbesondere bei Hochtemperaturprozessen in das Silizium eindiffundieren und die elektrischen oder mechanischen Eigenschaften des Materials lokal verändern können.
Partikelkontamination erfolgt durch Anlagerungen aus Umgebungsluft, Gasen und Flüssigkeiten. Starke Quellen sind durch bewegliche Teile in Maschinen erzeugter Abrieb sowie abplatzende Schichten z. B. in CVD (Chemical Vapor deposition)-Prozessen. Anlagerung und Haftung der Partikel sind dabei stark vom jeweiligen elektrostatischen Ladungszustand abhängig. An der Scheibenoberfläche anhaftende Partikel führen in Fotoprozessen zu inhomogenen Lackdicken sowie Kurzschlüssen oder Unterbrechungen der Lackbahnen. Ätz- und Implantationsprozesse können lokal maskiert werden, so dass hier ebenfalls Kurzschlüsse und Unterbrechungen auftreten können. Der Einbau von Partikeln in Isolatorschichten ergibt Stellen mit verminderter Durchbruchfestigkeit oder vertikalen Kurzschlüssen.
Metallkontamination erfolgt ebenfalls durch Anlagerungen aus der Umgebungsluft, Gasen und Flüssigkeiten; Kontamination durch Metalle ergibt sich häufig durch Abrieb von beweglichen Metallteilen, aber auch durch Absputtern von Metallteilen in den Prozesskammern in Plasmaprozessen. Da Metallatome beim Einbau im Siliziumgitter meist tiefliegende Störstellenniveaus ergeben, führt ihre Eindiffusion bei Hochtemperaturprozessen zu erhöhter Rekombination der Ladungsträger und verminderter Minoritätsträgerlebensdauer; weiterhin wirken sie als Quelle für oxidationsinduzierte Stapelfahler. Metallkontamination erfordert für den Nachweis meist einen hohen analytischen Aufwand.

Effektive Reinigungsverfahren und/oder Trockenverfahren müssen daher die oben beschriebenen Kontaminationen zwischen den Prozessschritten beseitigen oder auf ein für die Funktionsfähigkeit der Bauelemente unkritisches Maß reduzieren.
Neben mechanischen Reinigungsverfahren sind vor allem trockenchemische und nasschemische Reinigungsverfahren bekannt.
Während manche Verbindungen durch einfaches Spülen in Reinstwasser oder de-ionisierten Wasser von der Scheibenoberfläche entfernt werden können, erfordern die weitaus meisten Kontaminaten jedoch zunächst die Überführung in einen löslichen Zustand. Zur Anwendung kommen hier saure oder basische Lösungen, Oxidationsmittel und Komplexbildner.

In der Praxis laufen die Reinigungs- und/oder Trockenschritte weitgehend automatisiert in zentrifugalen Sprühsystemen ab.

Bei derartigen Prozessen kommen üblicherweise Schleudern zum Einsatz, in denen die einzelnen Schritte des Herstellungsprozesses ablaufen. Die Schleudern verfügen dabei über eine Trommel, in der die Wafer während des Prozessschrittes gehalten werden. Die Trommel ist wiederum drehbar in einer Kammer angeordnet, in denen Düsen angeordnet sind, die die Wafer mit Flüssigkeiten oder Gasen besprühen. Während des Schleuderprozesses dreht sich die Trommel mit hoher Geschwindigkeit, um einerseits für eine gute Verteilung der Flüssigkeiten auf den Wafer zu sorgen und um andererseits im Trockenvorgang für eine Beseitigung der Flüssigkeiten auf der Waferoberfläche mittels Zentrifugalkraft zu sorgen.
Da es bei der Herstellung von Halbleiterbauelementen auf große defektfreie Stückzahlen in geringer Zeit ankommt, ist zusätzlich darauf zu achten, dass die Reinigungsprozesse in einer angemessenen Zeit stattfinden.

Nachteilig an den bekannten Reinigungs- und Trockenvorrichtungen ist, dass sie üblicherweise aus einer Stahllegierung bestehen. Da bei den Reinigungs- und Trockenprozessen grundsätzlich Flüssigkeiten, beispielsweise de-ionisiertes Wasser, eingesetzt werden, die Atome aus den Stahllegierungen lösen können, besteht die Gefahr, dass gerade Fremdatome wie z.B. Vanadium, Tantal, Wolfram oder Gold, insbesondere aber Eisen, Chrom, Nickel, Sauerstoff und Kohlenstoff gelöst werden, in Kontakt mit den Wafern kommen und bei den nachfolgenden Temperaturprozessen in die Gitterstruktur des Siliziums eindringen. Gerade Eisenatome können besonders leicht an den Oberflächen der Wafer anhaften, wobei es dann nach Temperaturprozessen zu Störstellenrekombinationen im Siliziumkristallgitter aufgrund von Kristalldefekten kommen kann. Wichtig für eine hohe Ladungsträgerlebensdauer und somit die Qualität der Wafer ist jedoch eine geringe Verunreinigung an Fremdatomen. Daraus resultieren hohe Anforderungen an die Reinheit der Ausgangsmaterialien und an alle Nass- und Hochtemperaturprozesse, bei denen besonders schnell Fremdatome eingebracht werden können.

Bei einem weiteren bekannten Verfahren zum Reinigen und Trocken von Wafern werden unter Ausnutzung des Marangoni-Effekts Medien wie Isopropanol oder Alkohol-/Wassergemische verwendet, wobei sehr gute Erfolge erzielt werden, allerdings sind die Geräte für dieses Verfahren weit teurer als für die herkömmlichen Verfahren.

Aufgabe der Erfindung ist es daher unter Vermeidung vorgenannter Nachteile die Partikelanzahl im Reinigungsprozess zu minimieren und die Kontamination mit Metallionen zu vermeiden.

Diese Aufgabe wird erfindungsgemäß durch eine Vorrichtung der eingangs genannten Art mit den Merkmalen des Patentanspruches 1 und durch ein Verfahren gemäß Patentanspruch 7 gelöst. Günstige Ausgestaltungsformen sind Gegenstand von Unteransprüchen.

Demnach besteht das Wesen der Erfindung darin, dass bei einer Waferbearbeitungsvorrichtung, die eine Prozesskammer und innerhalb der Prozesskammer eine Anordnung von Einlassöffnungen und eine drehbare Aufnahmevorrichtung für Wafer umfasst, wobei die Wafer in Waferträgern angeordnet und mittels dieser an der drehbaren Aufnahmevorrichtung fixiert sind, eine Beschichtung aus einem Fluorpolymer auf allen Fluid berührenden Teilen der Waferbearbeitungsvorrichtung vorgesehen ist. Da selbst das deionisierte Wasser, das zum Reinigen verwendet wird, immer noch schädliche Partikel enthält, besteht grundsätzlich die Gefahr, dass diese Partikel an der Oberfläche der Prozesskammer haften bleiben und beim nächsten Reinigungsvorgang die Wafer kontaminieren. Im Gegensatz zu einer Oberfläche aus Stahl oder Edelstahl ist die Oberfläche des Fluorpolymers hydrophob, daher bleibt kein Wasser, das eventuell Partikel enthalten könnte, an der Oberfläche haften.
Optische und elektronische Untersuchungen der Anmelderin haben gezeigt, dass die Partikelanzahl auf den Wafern nach dem Reinigen in einer erfindungsgemäßen Vorrichtung in einen Bereich unter 2 bis 5 Partikel pro Wafer gesunken ist, während vor dem Einsatz der Vorrichtung die Partikelanzahl zwischen 10 und 25 lag.

Als besonders vorteilhaft hat sich hierbei eine Beschichtung erwiesen, bei dem als Fluorpolymer Polytetrafluorethylen (PTFE) vorgesehen ist. Dieses weist eine sehr geringe Oberflächenspannung auf, so dass keine Partikel und kein Reinigungsfluid an der Oberfläche haften bleiben können. Weiterhin bietet eine Beschichtung aus PTFE den Vorteil, dass sie im Gegensatz zu anderen Fluorpolymeren sehr dünn aufgetragen werden kann. Daher treten auch bei einer Nachrüstung an den Maschinen nur geringe Massenänderungen auf. Dies ist bei den zentrifugalen Waferbearbeitungsvorrichtungen von großer Bedeutung, damit es nicht zu Unwuchten bei der Rotation kommt.

Eine andere Ausgestaltung der Erfindung sieht vor, dass das Fluorpolymer ein Perfluoralkoxy-Copolymerisat (PFA) ist.

Gemäß einer vorteilhaften Weiterbildung der Erfindung ist unter der Beschichtung aus einem Fluorpolymer eine Hartschicht, vorzugsweise aus Siliziumcarbid (SiC, S-SiC oder Si-SiC) vorgesehen. Von besonderem Vorteil ist weiterhin, wenn die Hartschicht über eine raue Oberfläche, ähnlich einer keramischen Oberfläche, die Spitzen und Täler aufweist, verfügt. Gemäß einer Weiterbildung der Erfindung wird die Beschichtung aus Fluorpolymer dünn, mit einer Schichtdicke in einem Bereich von 40 bis 100 µm, aufgetragen.

Da Waferbearbeitungsvorrichtungen üblicherweise von außen mittels Heizmatten oder ähnlichem für einzelne Prozessschritte beheizt werden, besteht der Vorteil einer dünnen Beschichtung darin, dass nicht zuviel Wärmeenergie aufgrund der isolierenden Eigenschaften der Beschichtung verloren geht.

Beim Auftrag der Fluorpolymerschicht auf die raue Hartschicht kann die Dicke der Fluorpolymerschicht auf den Spitzen der Hartschichtoberfläche im Bereich von wenigen µm liegen, während sich in den Tälern eine Schicht mit der vorgenannten Schichtstärke von 40 bis 100 µm sammelt. Bei mechanischer Beanspruchung der Oberfläche verbleibt somit in den Tälern der Hartschicht die Fluorpolymerschicht auch dann, wenn die Spitzen beschädigt werden sollten. Dadurch bleiben die Eigenschaften der Oberfläche insgesamt gewahrt.

Weiterhin sieht die Erfindung ein Verfahren zur Bearbeitung eines Wafers vor, bei welchem zunächst ein oder mehrere Wafer in eine drehbare Aufnahmevorrichtung einer Prozesskammer eingelegt werden, wobei die Aufnahmevorrichtung mit einer Beschichtung aus einem Fluorpolymer versehen ist. Nachdem die Wafer fixiert und die Prozesskammer verschlossen ist, wird ein Fluid, auf die Oberfläche der Wafer mittels der in der Prozesskammer angeordneten Einlassöffnungen aufgebracht. Im Anschluss an den Reinigungs- und Spülvorgang werden die Wafer durch Drehen der Aufnahmevorrichtung unter Ausnutzung der Zentrifugalkraft getrocknet.

Anhand der Figuren soll die Erfindung näher beschrieben werden.
Fig. 1 zeigt einen Längsschnitt durch eine Waferbearbeitungsvorrichtung
Fig. 2 zeigt einen Querschnitt durch eine Waferbearbeitungsvorrichtung
Fig. 3 zeigt Messergebnisse von der Anzahl der Partikel pro Wafer vor und nach dem Einsatz der erfindungsgemäßen Vorrichtung bzw. des erfindungsgemäßen Verfahrens

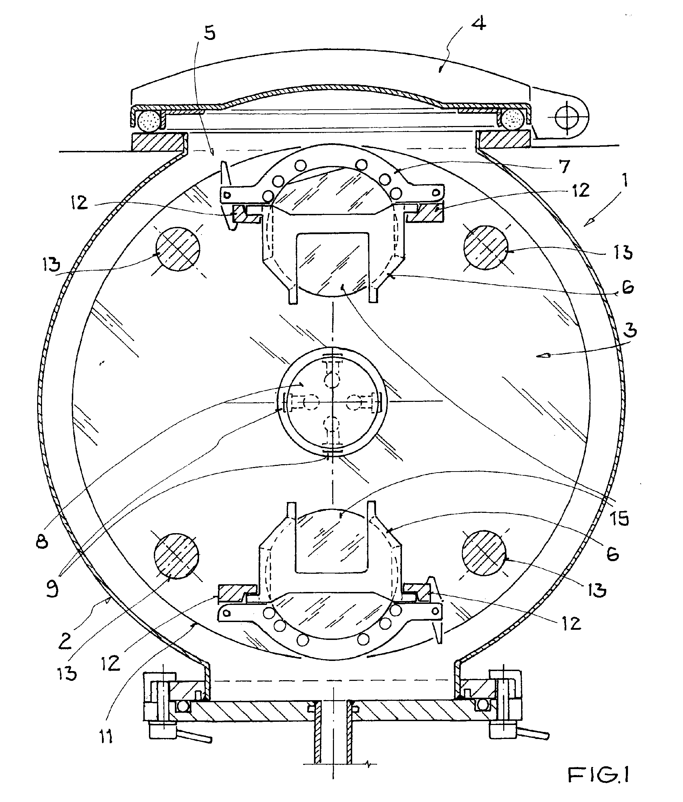

Fig. 1 zeigt einen Längsschnitt durch eine Waferbearbeitungsvorrichtung 1. Diese Vorrichtung weist abgeschlossen durch ein zylinderförmiges Gehäuse 2 eine Prozesskammer 3 auf, in der eine rotierende Aufnahmevorrichtung 11 für mindestens einen Waferträger 6 angeordnet ist. Während des Reinigungsprozesses wird die Aufnahmevorrichtung 11 durch einen Rotationsantrieb 10, der das Gehäuse 2 durchdringt, in Bewegung versetzt. In der Prozesskammer 3 ist außerdem ein Düsenstock 8 angeordnet, der mehrere Einlassöffnungen 9 aufweist, die die jeweilige Reinigungsflüssigkeit oder ein Gas in die Prozesskammer 3 einleiten.
Die Aufnahmevorrichtung 11 enthält je zwei Haltestangen 12, in welche der Waferträger 6 eingehängt werden kann. Damit die Wafer 15 auch während der Rotationsbewegung fixiert sind, werden sie durch einen Verschluss 7, der gelenkig an einer der Haltestangen 12 befestigt ist, nieder gehalten.

Die Aufnahmevorrichtung 11 ist auf beiden Seiten des Gehäuses 2 mit Rotationslagern 14 versehen. Zur Aussteifung der Aufnahmevorrichtung 11 sind insgesamt vier Streben 13 jeweils auf beiden Seiten der Waferträger 6 angeordnet.
Bei der vorliegenden Ausführungsform ist der Düsenstock 8 axial verschieblich in der Mitte des Gehäuses 2 angeordnet. Es sind aber auch Ausführungsformen denkbar, bei denen der Düsenstock 8 auf dem Boden des Gehäuses 2 fest fixiert ist.

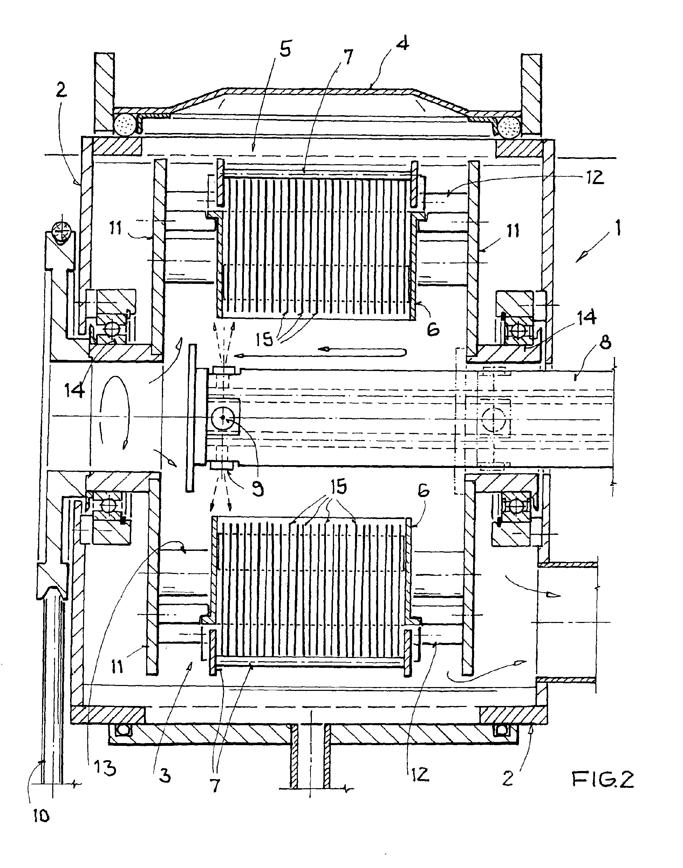

Fig. 2 zeigt einen Querschnitt durch die Waferbearbeitungsvorrichtung 1. Der Deckel 4 ist gelenkig am Gehäuse 2 befestigt und ermöglicht das Be- und Entladen der Prozesskammer 3. Reinigungflüssigkeiten und -gase werden durch die Einlassöffnungen 9 des Düsenstocks 8 in der Prozesskammer 3 verteilt.

Neben dem Gehäuse 2 und dessen abschließenden Deckel 4 sind sowohl die Aufnahmevorrichtung 11 und deren Einzelteile, wie Haltestangen 12 und Streben 13 als auch die Rotationslager 14 üblicherweise aus Stahl oder Edelstahl hergestellt. Während des Reinigungsprozesses werden alle diese innen liegenden Konstruktionsteile von der Reinigungsflüssigkeit oder -gas umspült. Die Beschichtung aus einem Fluorpolymer auf den einzelnen Teilen der Waferbearbeitungsvorrichtung 1 sorgt dafür, dass sich keine Metallionen lösen könnten, die die vorgenannten Schäden an den Wafern 15 hervorrufen können und dass sich von den Wafern 15 beim Reinigen gelöste Partikel nicht in der Waferbearbeitungsvorrichtung 1 ablagern.

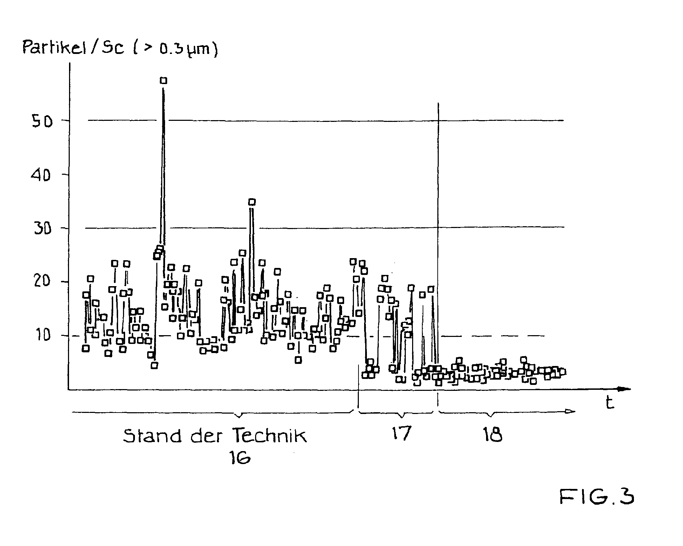

In dem Diagramm der Fig.3 sind die Anzahl der Partikel, die größer als 0,3 µm sind und die nach dem Reinigungsvorgang noch an der Oberfläche eines Wafers gemessen werden können über einer Zeitachse 16, 17, 18 aufgetragen. Der erste Bereich 16 gibt die Partikelanzahl nach Reinigungs- und Trockenvorgängen in herkömmlichen Waferbearbeitungsvorrichtungen nach dem Stand der Technik an. Im zweiten Bereich 17 wurden Messungen nach dem Einsatz von herkömmlichen und der Erprobung der erfindungsgemäßen Waferbearbeitungsvorrichtung durchgeführt. Der Bereich 18 gibt schließlich die Partikelanzahl nach dem Einsatz der erfindungsgemäßen Vorrichtung wieder. Hierbei entspricht jeder Messwert der Anzahl der gemessenen Partikel an einem Wafer. Während die Anzahl der Partikel vor dem Einsatz der Erfindung zwischen 5 und 25 schwankt, liegt die Partikelanzahl ab dem Einsatz der erfindungsgemäßen Vorrichtung in einem Bereich zwischen 2 und 5 Partikel pro Wafer.

### Bezugszeichenliste

- 1: Waferbearbeitungsvorrichtung
- 2: Gehäuse
- 3: Prozesskammer
- 4: Deckel
- 5: Öffnung
- 6: Waferträger
- 7: Verschluss
- 8: Düsenstock
- 9: Einlassöffnung
- 10: Rotationsantrieb
- 11: Rotierende Aufnahmevorrichtung
- 12: Haltestangen
- 13: Streben
- 14: Rotationslager
- 15: Wafer
- 16: Stand der Technik
- 17: Erprobung und Vergleichslauf
- 18: Einsatz der erfindungsgemäßen Vorrichtung

## Patentansprüche

1. Waferbearbeitungsvorrichtung (1), umfassend
• eine Prozesskammer (3) umgeben von einem Gehäuse (2),
• eine Anordnung von Einlassöffnungen (9) innerhalb der Prozesskammer (3), die dazu vorgesehen sind, ein Fluid abzugeben und
• eine drehbare Aufnahmevorrichtung (11) für Wafer (15) innerhalb der Prozesskammer (3), wobei die Wafer (15) in einem Waferträger (6) angeordnet sind, der an der Aufnahmevorrichtung (11) fixiert ist,
wobei
• auf allen Fluid berührenden Teilen der Waferbearbeitungsvorrichtung (1) eine Beschichtung aus einem Fluorpolymer vorgesehen ist.

2. Waferbearbeitungsvorrichtung (1) gemäß Anspruch 1, **dadurch gekennzeichnet, dass** unter der Beschichtung aus einem Fluorpolymer eine Hartschicht, vorzugsweise aus Siliziumcarbid SiC vorgesehen ist.

3. Waferbearbeitungsvorrichtung (1) gemäß Anspruch 2, **dadurch gekennzeichnet, dass** die Hartschicht mit einer rauen Oberfläche vorgesehen ist.

4. Waferbearbeitungsvorrichtung (1) gemäß einem der vorhergehenden Ansprüche, **dadurch gekennzeichnet, dass** das Fluorpolymer ein Polytetrafluorethylen (PTFE) ist.

5. Waferbearbeitungsvorrichtung (1) gemäß einem der Ansprüche 1 bis 3, **dadurch gekennzeichnet, dass** das Fluorpolymer ein Perfluoralkoxy-Copolymerisat (PFA) ist.

6. Waferbearbeitungsvorrichtung (1) gemäß einem der vorhergehenden Ansprüche, **dadurch gekennzeichnet, dass** das Fluorpolymer mit einer Schichtdicke von 40 bis 100 µm vorgesehen ist.

7. Verfahren zur Bearbeitung eines Wafers (15) mit den Schritten
• Einlegen wenigstens eines Waferträgers (6) mit wenigstens einem Wafer (15) in eine drehbare Aufnahmevorrichtung (11) einer Prozesskammer (3), wobei die Aufnahmevorrichtung (11) mit einer Beschichtung aus einem Fluorpolymer versehen ist;
• Aufbringen eines Fluids auf die Oberfläche der Wafer (15) mittels in der Prozesskammer (3) angeordneter Einlassöffnungen (9);
• Trocknen der Wafer (15) durch Drehen der Aufnahmevorrichtung (11) unter Ausnutzung der Zentrifugalkraft.
